# EUROPEAN PATENT APPLICATION

(11) **EP 1 403 717 A1**
(43) Date of publication of application: **31.03.2004**
(21) Application number: 03021393.8
(22) Date of filing: 22.09.2003
(51) Int. Cl.: G03F 7/40, G03F 7/00, H01L 21/027, H01L 21/8247, H01L 27/115

(54) **Resist pattern thickening material, process for forming resist pattern, and process for manufacturing semiconductor device**

(30) Priority: 30.09.2002 JP 2002288117
(71) Applicant: FUJITSU LIMITED, Kawasaki-shi, Kanagawa 211-8588 (JP)
(72) Inventor: Kozawa, Miwa, Kawasaki-shi Kanagawa 211-8588 (JP); Nozaki, Koji, Kawasaki-shi Kanagawa 211-8588 (JP)
(74) Representative: Körfer, Thomas

(57) **Abstract**

The present invention provides a resist pattern thickening material and the like which can thicken a resist pattern and form a fine space pattern, exceeding exposure limits of exposure light used during patterning. The resist pattern thickening material contains a resin and a surfactant. In a process for forming a resist pattern of the present invention, after a resist pattern to be thickened is formed, the resist pattern thickening material is coated on a surface thereof. A process for manufacturing a semiconductor device of the present invention includes: a step of, after forming a resist pattern to be thickened on an underlying layer, coating the thickening material on a surface of the resist pattern to be thickened so as to thicken the resist pattern to be thickened and form a resist pattern; and a step of patterning the underlying layer by etching by using the resist pattern.

## Description

### CROSS-REFERENCE TO RELATED APPLICATIONS

This application is based upon and claims the benefit of priority from the prior Japanese Patent Application No. 2002-288117, filed on September 30, 2002, the entire contents of which are incorporated herein by reference.

### BACKGROUND OF THE INVENTION

### Field of the Invention

The present invention relates to a resist pattern thickening material which is coated on a resist pattern to be thickened and thickens the resist pattern to be thickened, and which can form a fine space pattern, exceeding exposure limits of light sources of existing exposure devices ("space pattern" is hereby defined as a hole, groove, recess, or any other empty space that is formed by a developed (removed) resist). The present invention also relates to a process for forming a resist pattern and a process for manufacturing a semiconductor device, all of which use the resist pattern thickening material.

### Description of the Related Art

Semiconductor integrated circuits are becoming more highly integrated, and LSIs and VLSIs are being put into practical use. Accompanying this trend, the wiring patterns extend to regions of 0.2 µm or less, and the smallest patterns extend to regions of 0.1 µm or less. A lithographic technique is extremely important in forming fine wiring patterns. In the lithographic technique, a substrate to be processed on which a thin film is formed, is coated by a resist film, is selectively exposed, and thereafter, is developed so as to form a resist pattern. Dry etching is carried out by using the resist pattern as a mask, and thereafter, by removing the resist pattern, the desired pattern is obtained.

In forming a fine wiring pattern, it is necessary to both make the light source of the exposure device be a short wavelength, and to newly develop resist materials which have high resolution and is suitable to the characteristics of the light source. However, in order to make a light source of an exposure device be a short wavelength, it is necessary to update the exposure device, which results in very high costs. Further, the development of new resist materials which is suitable to exposure using short wavelength light sources is not easy.

Further, in the process of manufacturing a semiconductor device, a fine space pattern is formed by the resist pattern. Because fine patterning is carried out by using the resist pattern as a mask, the resist pattern should have excellent etching resistance. However, in an ArF excimer laser light exposure technique which is the latest technique, there is the problem that the etching resistance of the resist material which is used is insufficient. Here, it has been thought to use KrF resists which have excellent etching resistance. However, in cases in which the etching conditions are severe, in cases in which the layer to be processed is thick, in cases in which a fine pattern is to be formed, in cases in which the resist is thin, and the like, the etching resistance may be insufficient. The development of a technique which can form a resist pattern having excellent etching resistance and can form a fine space pattern by this resist pattern has been desired.

Japanese Patent Application Laid-Open (JP-A) No. 10-73927 and the like disclose a technique for making a space pattern fine. This technique is called RELACS, and can form a fine space pattern by using KrF (krypton fluoride) excimer laser light (wavelength: 248 nm) which is deep ultraviolet light as the exposure light of a resist. In this technique, a resist pattern is formed by exposing a resist (a positive resist or a negative resist) by using a KrF (krypton fluoride) excimer laser light (wavelength: 248 nm) as the exposure light. Thereafter, by using a water-soluble resin composition, a coated film is provided so as to cover the resist pattern. The coated film and the resist pattern are made to interact at the interface thereof by using the residual acid within the material of the resist pattern, and the resist pattern is thickened. (Hereinafter, this thickening of the resist pattern will be referred to upon occasion as "swelling".) In this way, the distance between the resist patterns is shortened, and a fine space pattern is formed.

However, in this case, the KrF resist which is used strongly absorbs ArF excimer laser light. Thus, the ArF excimer laser light cannot pass through the KrF resist. There is therefore the problem that ArF excimer laser light cannot be used as the exposure light.

From the standpoint of forming a fine wiring pattern, it is desirable to be able to use ArF excimer laser light, which is light of a shorter wavelength than KrF excimer laser light, as the light source of the exposure device.

Accordingly, the current situation is that there has not yet been developed a technique which can use ArF excimer laser light as the light source of an exposure device during patterning, and which can form a fine space pattern.

### SUMMARY OF THE INVENTION

An object of the present invention is to provide a process for forming a resist pattern which, during patterning a resist pattern to be thickened, can utilize, as is, light sources (such as ArF excimer laser light and the like) of existing exposure devices, and which has excellent mass productivity, and which can finely manufacture a space pattern, exceeding the exposure limits of such light sources, regardless of the material or the size of the resist pattern to be thickened.

Another object of the present invention is to provide a resist pattern thickening material which, when coated on a resist pattern to be thickened, can efficiently thicken the resist pattern to be thickened regardless of the material or the size of the resist pattern to be thickened, and which is suited to the manufacture of a fine space pattern, exceeding the exposure limits of light sources of existing exposure devices.

Yet another object of the present invention is to provide a process for manufacturing a semiconductor device which, by using a space pattern which has been formed to be fine, can form a fine pattern on an underlying layer which is an oxide film or the like, and which can efficiently mass produce high-performance semiconductor devices having fine wiring and the like.

The resist pattern thickening material of the present invention comprises a resin and a surfactant. When the resist pattern thickening material is coated on a resist pattern to be thickened, among the coated resist pattern thickening material, the portions thereof in a vicinity of the interface with the resist pattern to be thickened seep into the resist pattern to be thickened. At this time, because the affinity between the resist pattern thickening material and the resist pattern to be thickened is good, a surface layer, in which the resist pattern thickening material and the resist pattern to be thickened have become integral, is efficiently formed on the surface of the resist pattern to be thickened. (The resist pattern to be thickened is efficiently thickened by the resist pattern thickening material.) The resist pattern which is formed in this way (which hereinafter will be termed "thickened resist pattern" upon occasion) has been thickened by the resist pattern thickening material. Thus, the space pattern formed by the resist pattern exceeds exposure limits and has a finer structure.

In the process for forming a resist pattern of the present invention, after a resist pattern to be thickened is formed, the resist pattern thickening material of the present invention is coated so as to cover a surface of the resist pattern to be thickened, such that a resist pattern, in which the resist pattern to be thickened has been thickened, is formed. In the process for forming a resist pattern of the present invention, when the resist pattern thickening material is coated on a formed resist pattern to be thickened, among the coated resist pattern thickening material, the portions thereof in a vicinity of the interface with the resist pattern to be thickened seep into the resist pattern to be thickened. Thus, at the surface of the resist pattern to be thickened, the resist pattern thickening material and the resist pattern to be thickened become integral, and the resist pattern to be thickened is thickened. The resist pattern which is formed in this way has been thickened by the resist pattern thickening material. Thus, the space pattern formed by the resist pattern exceeds exposure limits and has a finer structure.

The process for manufacturing a semiconductor device of the present invention comprises: a resist pattern forming step in which, after a resist pattern to be thickened is formed on an underlying layer, the resist pattern thickening material of the present invention is coated so as to cover a surface of the resist pattern to be thickened, thereby thickening the resist pattern and forming a resist pattern; and a patterning step of patterning the underlying layer by etching using the resist pattern. In the process for manufacturing a semiconductor device of the present invention, after a resist pattern to be thickened is formed on an underlying layer, the resist pattern thickening material - is coated on the resist pattern to be thickened. Then, among the coated resist pattern thickening material, the portions thereof in a vicinity of the interface with the resist pattern to be thickened seep into the resist pattern to be thickened. Thus, at the surface of the resist pattern to be thickened, the resist pattern thickening material and the resist pattern to be thickened become integral, and the resist pattern to be thickened is thickened. The resist pattern which is formed in this way has been thickened by the resist pattern thickening material. Thus, the space pattern formed by the resist pattern exceeds exposure limits and has a finer structure. Further, because the underlying layer is patterned by etching using the resist pattern as a mask, a high-quality, high-performance semiconductor device having an extremely fine pattern is efficiently fabricated.

### BRIEF DESCRIPTION OF THE DRAWINGS

FIGs. 1A to 1C are schematic diagrams for explaining one example of the mechanism of thickening a resist pattern to be thickened by using a resist pattern thickening material of the present invention.
FIGs. 2A to 2E are schematic diagrams for explaining an example of a process for forming a resist pattern of the present invention.
FIGs. 3A to 3D are part 1 of schematic diagrams for explaining an example of a process for manufacturing a semiconductor device having a multilayer wiring structure, by using a process for - manufacturing a semiconductor device of the present invention.
FIGS. 4A to 4D are part 2 of the schematic diagrams for explaining the example of the process for manufacturing a semiconductor device having a multilayer wiring structure, by using the process for manufacturing a semiconductor device of the present invention.
FIG. 5 is part 3 of the schematic diagrams for explaining the example of the process for manufacturing a semiconductor device having a multilayer wiring structure, by using the process for manufacturing a semiconductor device of the present invention.
FIGs. 6A and 6B are top views for explaining a FLASH EPROM which is one example of a semiconductor device of the present invention.
FIGs. 7A to 7C are part 1 of a set of cross-sectional schematic diagrams for explaining a process for manufacturing the FLASH EPROM which is an example of the process for manufacturing a semiconductor device of the present invention.
FIGs. 8D to 8F are part 2 of the set of cross-sectional schematic diagrams for explaining the process for manufacturing the FLASH EPROM which is an example of the process for manufacturing a semiconductor device of the present invention.
FIGs. 9G to 9I are part 3 of the set of cross-sectional schematic diagrams for explaining the process for manufacturing the FLASH EPROM which is an example of the process for manufacturing a semiconductor device of the present invention.
- FIGs. 10A to 10C are cross-sectional schematic diagrams for explaining a process for manufacturing a FLASH EPROM which is another example of a process for manufacturing a semiconductor device of the present invention.
FIGs. 11A to 11C are cross-sectional schematic diagrams for explaining a process for manufacturing a FLASH EPROM which is another example of a process for manufacturing a semiconductor device of the present invention.
FIGs. 12A to 12D are cross-sectional schematic diagrams for explaining an example in which a resist pattern, which has been thickened by using the resist pattern thickening material of the present invention, is applied to the fabricating of a recording head.
FIG. 13 is a cross-sectional schematic diagram for explaining part 1 of a process of another example in which a resist pattern, which has been thickened by using the resist pattern thickening material of the present invention, is applied to the fabricating of a recording head.
FIG. 14 is a cross-sectional schematic diagram for explaining part 2 of the process of the other example in which the resist pattern, which has been thickened by using the resist pattern thickening material of the present invention, is applied to the fabricating of the recording head.
FIG. 15 is a cross-sectional schematic diagram for explaining part 3 of the process of the other example in which the resist pattern, which has been thickened by using the resist pattern thickening material of the present invention, is applied to the fabricating of the - recording head.
FIG. 16 is a cross-sectional schematic diagram for explaining part 4 of the process of the other example in which the resist pattern, which has been thickened by using the resist pattern thickening material of the present invention, is applied to the fabricating of the recording head.
FIG. 17 is a cross-sectional schematic diagram for explaining part 5 of the process of the other example in which the resist pattern, which has been thickened by using the resist pattern thickening material of the present invention, is applied to the fabricating of the recording head.
FIG. 18 is a cross-sectional schematic diagram for explaining part 6 of the process of the other example in which the resist pattern, which has been thickened by using the resist pattern thickening material of the present invention, is applied to the fabricating of the recording head.
FIG. 19 is a plan view showing an example of the recording head fabricated by the processes of FIGS. 13 through 18.

### DESCRIPTION OF THE PREFERRED EMBODIMENTS

### (Resist Pattern Thickening Material)

The resist pattern thickening material of the present invention comprises a resin and a surfactant. As needed, the resist pattern thickening material may also include a cyclic structure-containing compound, an organic solvent, and/or other components which are appropriately selected.

The resist pattern thickening material of the present invention is water-soluble or alkali-soluble.

The resist pattern thickening material of the present invention may be an aqueous solution, a colloid liquid, an emulsion liquid or the like, but an aqueous solution is preferable.

### - Resin-

The resin is not particularly limited, and can be appropriately selected in accordance with the object. However, it is preferable that the resin is water-soluble or alkali-soluble.

A resin may be used singly, or two or more may be used in combination.

When the resin is water-soluble, the water-soluble resin preferably exhibits water solubility of 0.1 g or more in 100 g of water of 25°C, and more preferably exhibits water solubility of 0.3 g or more in 100 g of water of 25°C, and particularly preferably exhibits water solubility of 0.5 g or more in 100 g of water of 25°C.

Examples of the water-soluble resin include polyvinyl alcohol, polyvinyl acetal, polyvinyl acetate, polyacrylic acid, polyvinyl pyrrolidone, polyethyleneimine, polyethylene oxide, styrene - maleic acid copolymer, polyvinylamine, polyarylamine, an oxazoline group-containing water-soluble resin, a water-soluble melamine resin, a water-soluble urea resin, an alkyd resin, a sulfonamide resin, and the like.

When the resin is alkali-soluble, the alkali-soluble resin preferably exhibits alkali solubility of 0.1 g or more in 100 g of 2.38% tetramethyl ammonium hydroxide (TMAH) aqueous solution of 25°C, and more preferably exhibits alkali solubility of 0.3 g or more in 100 g of 2.38% TMAH aqueous solution of 25°C, and particularly preferably exhibits alkali solubility of 0.5 g or more in 100 g of 2.38% TMAH aqueous solution of 25°C.

Examples of the alkali-soluble resin are a novolak resin, a vinylphenol resin, polyacrylic acid, polymethacrylic acid, poly p-hydroxyphenylacrylate, poly p-hydroxyphenylmethacrylate, a copolymer thereof, and the like.

In the present invention, the resin may be a resin having a cyclic structure in at least a portion thereof.

In such case, the cyclic structure is not particularly limited, and can be appropriately selected in accordance with the object. Suitable examples are structures selected from at least one of an aromatic compound, an alicyclic compound, and a heterocyclic compound.

Examples of aromatic compounds are a polyhydric phenol compound, a polyphenol compound, an aromatic carboxylic acid compound, a naphthalene polyhydroxy compound, a benzophenone compound, a flavonoid compound, a porphin, a water-soluble phenoxy resin, an aromatic-containing water-soluble dye, a derivative thereof, a glycoside thereof, and the like. The aromatic compound may be used singly, or two or more may be used in combination.

Examples of the polyhydric phenol compound are resorcinol, resorcin[4]arene, pyrogallol, gallic acid, a derivative and a glycoside thereof, and the like.

Examples of the polyphenol compound and a derivative thereof include catechin, anthocyanidin (pelargonidin-type (4'-hydroxy), cyanidin-type (3',4'-dihydroxy), delphinidin-type (3',4',5'-trihydroxy)), flavan-3,4-diol, proanthocyanidin, a derivative and a glycoside thereof, and the like.

Examples of the aromatic carboxylic acid compound and a derivative thereof include salicylic acid, phthalic acid, dihydroxy benzoic acid, tannin, a derivative and a glycoside thereof, and the like.

Examples of the naphthalene polyhydroxy compound and a derivative thereof include naphthalene diol, naphthalene triol, a derivative and a glycoside thereof, and the like.

Examples of the benzophenone compound and a derivative thereof include alizarin yellow A, a derivative and a glycoside thereof, and the like.

Examples of the flavonoid compound and a derivative thereof include flavone, isoflavone, flavanol, flavonone, flavonol, flavan-3-ol, aurone, chalcone, dihydrochalcone, quercetin, a derivative and a glycoside thereof, and the like.

Examples of the alicyclic compound are a polycycloalkane, a cycloalkane, fused rings, a derivative and a glycoside thereof, and the like. The alicyclic compound may be used singly, or two or more may be used in combination.

Examples of the polycycloalkane are norbornane, adamantane, norpinane, sterane, and the like.

Examples of the cycloalkane are cyclopentane, cyclohexane, and the like.

Examples of the fused rings are steroids and the like.

Suitable examples of the heterocyclic compound include a nitrogen-containing cyclic compound such as pyrrolidine, pyridine, imidazole, oxazole, morpholine, pyrrolidone, and the like; and an oxygen-containing cyclic compound such as furan, pyran, saccharides such as pentose and hexose, and the like.

Among the resins having a cyclic structure in at least a portion thereof, those having two or more polar groups are preferable from the standpoint of excellence in at least one of water solubility and alkali solubility.

The polar group is not particularly limited and can be appropriately selected in accordance with the object. Examples include hydroxyl group, carboxyl group, carbonyl group, sulfonyl group, and the like.

In the case of a resin having a cyclic structure in at least a portion thereof, the resin portion other than the cyclic structure is not particularly limited and can be appropriately selected in accordance with the object, provided that the resin on the whole is water-soluble or alkali-soluble. Examples include a water-soluble resin such as polyvinyl alcohol, polyvinyl acetal, and the like, and a alkali-soluble resin such as a novolak resin, a vinylphenol resin, and the like.

When the resin has a cyclic structure in at least a portion thereof, the molar content of the cyclic structure is not particularly limited and can be appropriately selected in accordance with the object. However, when high etching resistance is needed, a molar content of 5 mol% or more is preferable, and 10 mol% or more is more preferable.

Note that the molar content can be measured by using, for example, NMR or the like.

The content of the resin in the resist pattern thickening material differs in accordance with the amount of the surfactant which will be described hereinafter and the like, and cannot be stipulated unconditionally, and can be appropriately selected in accordance with the object.

### - Surfactant-

The surfactant is not particularly limited and can be appropriately selected in accordance with the object. Examples include a non-ionic surfactant, a cationic surfactant, an anionic surfactant, an amphoteric surfactant, and the like. The surfactant may be used singly, or two or more may be used in combination. Among these, a non-ionic surfactant is preferable from the standpoint that they do not contain metal ions.

Suitable examples of a non-ionic surfactant include a surfactant selected from among an alkoxylate surfactant, a fatty acid ester surfactant, an amide surfactant, an alcohol surfactant, and an ethylene diamine surfactant. Specific examples thereof include a polyoxyethylene - polyoxypropylene condensation product compound, a polyoxyalkylene alkylether compound, a polyoxyethylene alkylether compound, a polyoxyethylene derivative compound, a sorbitan fatty acid ester compound, a glycerin fatty acid ester compound, a primary alcohol ethoxylate compound, a phenol ethoxylate compound, and a nonylphenol ethoxylate surfactant, an octylphenol ethoxylate surfactant, a lauryl alcohol ethoxylate surfactant, a oleyl alcohol ethoxylate surfactant, a fatty acid ester surfactant, an amide surfactant, a natural alcohol surfactant, an ethylene diamine surfactant, and a secondary alcohol ethoxylate surfactant, and the like.

The cationic surfactant is not particularly limited and can be appropriately selected in accordance with the object. Examples include an alkyl cationic surfactant, an amide quaternary cationic surfactant, an ester quaternary cationic surfactant, and the like.

The amphoteric surfactant is not particularly limited and can be appropriately selected in accordance with the object. Examples include an amine oxide surfactant, a betaine surfactant, and the like.

The content of the surfactant in the resist pattern thickening material differs in accordance with the type, the content, and the like of the resin and the like, and cannot be stipulated unconditionally, and can be appropriately selected in accordance with the object.

### - Cyclic Structure-Containing Compound

From the standpoint of markedly improving the etching resistance of the obtained resist pattern, the resist pattern thickening material preferably further contains a cyclic structure-containing compound.

The cyclic structure-containing compound is not particularly limited provided that it contains a cyclic structure, and can be appropriately selected in accordance with the object. The cyclic structure-containing compound encompasses not only compounds but resins as well, and is preferably water-soluble or alkali-soluble.

When the cyclic structure-containing compound is water-soluble, the cyclic structure-containing compound preferably exhibits water solubility of 0.1 g or more, and more preferably exhibits water solubility of 0.3 g or more, and particularly preferably exhibits water solubility of 0.5 g or more, in 100 g of water of 25°C.

When the cyclic structure-containing compound is alkali-soluble, the cyclic structure-containing compound preferably exhibits alkali solubility of 0.1 g or more, and more preferably exhibits alkali solubility of 0.3 g or more, and particularly preferably exhibits alkali solubility of 0.5 g or more, in 100 g of 2.38% tetramethyl ammonium hydroxide (TMAH) aqueous solution of 25°C.

Suitable examples of the cyclic structure-containing compound are an aromatic compound, an alicyclic compound, a heterocyclic compound, and the like. Details regarding these compounds are the same as those described above, and the preferable compounds thereamong are the same as described above.

Among the cyclic structure-containing compounds, those having two or more polar groups are preferable, those having three or more polar groups are more preferable, and those having four or more polar groups are particularly preferable, from the standpoint of excellence in at least one of water solubility and alkali solubility.

The polar groups are not particularly limited, and can be appropriately selected in accordance with the object. Examples include hydroxyl group, carboxyl group, carbonyl group, sulfonyl group, and the like.

When the cyclic structure-containing compound is a resin, the molar content of the cyclic structure with respect to the resin is not particularly limited and can be appropriately selected in accordance with the object. However, when high etching resistance is needed, a molar content of 5 mol% or more is preferable, and 10 mol% or more is more preferable.

Note that the molar content can be measured by using, for example, NMR or the like.

The content of the cyclic structure-containing compound in the resist pattern thickening material can be appropriately determined in accordance with the type, the content, and the like of the resin and the like.

### - Organic Solvent-

The resist pattern thickening material may contain organic solvents to improve the solubility of the resin, the surfactant, and the like in the resist pattern thickening material.

The organic solvent is not particularly limited, and can be appropriately selected in accordance with the object. Examples include alcohols, straight chain esters, cyclic esters, ketones, straight chain ethers, cyclic ethers, and the like.

Examples of the alcohols are methanol, ethanol, propyl alcohol, isopropyl alcohol, butyl alcohol, and the like.

Examples of the straight chain esters are ethyl lactate, propylene glycol methyl ether acetate (PGMEA), and the like.

Examples of the cyclic esters are lactones such as γ-butyrolactone, and the like.

Examples of the ketones are acetone, cyclohexanone, heptanone, and the like.

Examples of the straight chain ethers are ethylene glycol dimethylether, and the like.

Examples of the cyclic ethers are tetrahydrofuran, dioxane, and the like.

The organic solvent may be used singly, or two or more may be used in combination. Thereamong, an organic solvent having a boiling point of around 80°C to about 200°C are preferable from the standpoint of carrying out thickening accurately.

The content of the organic solvent in the resist pattern thickening material can be appropriately determined in accordance with the type, the content, and the like of the resin, the surfactant, and the like.

### - Other Components-

The other components are not particularly limited provided that they do not adversely affect the effects of the present invention, and can be appropriately selected in accordance with the object. Examples are various types of known additives such as crosslinking agents, thermal acid generating agents, quenchers such as amine type, amide type, ammonium chloride type quenchers, and the like.

The content of the other components in the resist pattern thickening material can be appropriately determined in accordance with the type, the content and the like of the resin, the surfactant, and the like.

### - Use and the like-

The resist pattern thickening material of the present invention can be used by being coated onto the resist pattern to be thickened.

At the time of coating, the surfactant may be coated before and separately from coating of the resist pattern thickening material, without being contained in the resist pattern thickening material.

When the resist pattern thickening material is coated on the resist pattern to be thickened, the resist pattern to be thickened thickens, and a resist pattern is formed.

The diameter or width (the dimension of the opening) of the space patterns formed in this way is smaller than those of the former space patterns. The exposure limit of the light source of the exposure device used at the time of patterning the resist pattern to be thickened is exceeded, such that an even finer space pattern is formed. For example, in a case in which ArF excimer laser light is used at the time of patterning the resist pattern to be thickened, when a resist pattern is formed by thickening the obtained resist pattern to be thickened by using the resist pattern thickening material of the present invention, the formed space pattern is a fine pattern which is comparable to that patterned by an electron beam.

Note that, at this time, the amount of thickening of the resist pattern to be thickened can be controlled to a desired degree by appropriately adjusting the viscosity of the resist pattern thickening material, the coating thickness of the resist pattern thickening material, the baking temperature, the baking time, and the like.

### - Material of Resist Pattern -

The material of the resist pattern to be thickened (the resist pattern on which the resist pattern thickening material of the present invention is coated) is not particularly limited, and can be appropriately selected from among known resist materials in accordance with the object. The material of the resist pattern to be thickened may be either of a negative type or a positive type. Suitable examples include g-line resists, i-line resists, KrF resists, ArF resists, F₂ resists, electron beam resists, and the like, which can be patterned by g-line, i-line, KrF excimer laser light, ArF excimer laser light, F₂ excimer laser light, electron beams, and the like, respectively. These resists may be chemically amplified types, or non-chemically amplified types. Among these, a KrF resist, an ArF resist, and the like are preferable, and an ArF resist is more preferable.

Specific examples of the material of the resist to be thickened are novolak resists, polyhydroxystyrene (PHS) resists, acrylic resists, cycloolefin - maleic acid anhydride (COMA) resists, cycloolefin resists, hybrid (alicyclic acryl - COMA copolymer) resists, and the like.
These materials may be fluorine-modified or the like.

The process for forming the resist pattern to be thickened, and the size, the thickness and the like of the resist pattern to be thickened are not particularly limited, and can be appropriately selected in accordance with the object. In particular, the thickness can be appropriately determined by the underlying layer which is the object of working, the etching conditions, and the like. However, the thickness is generally about 0.2 µm to 200 µm.

The thickening of the resist pattern to be thickened by using the resist pattern thickening material of the present invention will be described hereinafter with reference to the drawings.

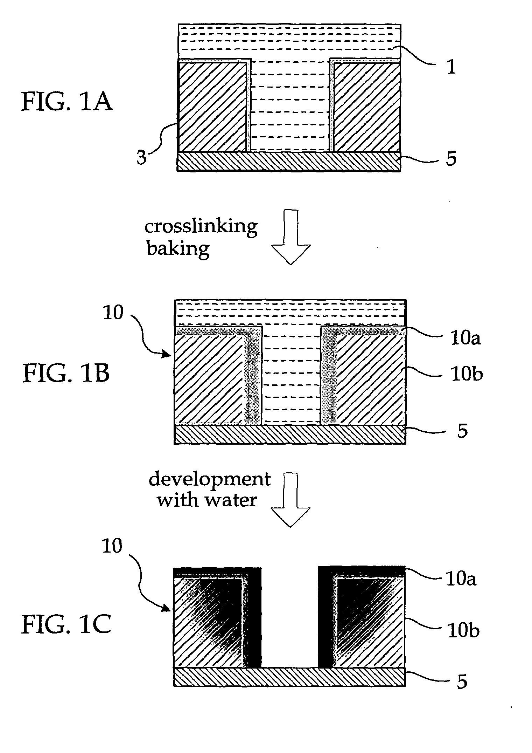

As shown in FIG.1A, after a resist pattern to be thickened 3 has been formed on an underlying layer (base) 5, a resist pattern thickening material 1 is coated on the surface of the resist pattern to be thickened 3. Prebaking (heating and drying) is carried out, such that a coated film is formed. Then, as shown in FIG. 1B, mixing (impregnation) of the resist pattern thickening material 1 into the resist pattern to be thickened 3 occurs at the interface between the resist pattern to be thickened 3 and the resist pattern thickening material 1. A surface layer 10a is formed by the aforementioned mixing (impregnation) at the interface of an inner layer resist pattern 10b (the resist pattern to be thickened 3) and the resist pattern thickening material 1.

Thereafter, as shown in FIG.1C, by carrying out developing processing, the portions, among the coated resist pattern thickening material 1, which have not mixed with the resist pattern to be thickened 3 are dissolved and removed, and a resist pattern 10 is formed (developed).

The developing processing may be performed in water or an alkali developer.

The resist pattern 10 has, on the surface of the resist pattern 10b (the resist pattern to be thickened 3), the surface layer 10a which has been formed by the resist pattern thickening material 1 by mixing. The resist pattern 10 is thicker than the resist pattern to be thickened 3 by an amount corresponding to the thickness of the surface layer 10a. Thus, the width of the space pattern formed by the resist pattern 10 is smaller than that of the former space patterns. Thus, the exposure limit of the light source of an exposure device at the time when the resist pattern to be thickened 3 is formed is exceeded, such that the space pattern can be formed to be fine. The space pattern formed by the resist pattern 10 is finer than the former space patterns.

The surface layer 10a of the resist pattern 10 is formed by the resist pattern thickening material 1. In a case in which the resist pattern thickening material 1 contains at least a cyclic structure compound and/ or a resin having a cyclic structure in a portion thereof, even if the resist pattern to be thickened 3 (the resist pattern 10b) is a material which has poor etching resistance, the obtained resist pattern 10 has, on the surface thereof, the surface layer 10a which contains at least one of a cyclic structure-containing compound and/ or a resin having a cyclic structure in a portion thereof. Therefore, the etching resistance is markedly improved.

### - Applications-

The resist pattern thickening material of the present invention can suitably be used in thickening a resist pattern to be thickened, and making a space pattern be fine, exceeding exposure limits. The resist pattern thickening material of the present invention is particularly suitably used in the process for manufacturing a semiconductor device of the present invention.

When the resist pattern thickening material of the present invention contains at least one of a cyclic structure-containing compound and/or a resin having a cyclic structure in a portion thereof, the resist pattern thickening material can suitably be used in covering and thickening a pattern which is exposed to plasma or the like and which is formed of resin or the like whose surface etching resistance must be improved, and can more suitably be used in cases in which at least one of a cyclic structure containing compound and/or a resin having a cyclic structure in a portion thereof cannot be used as the material of the pattern.

### (Process for forming Resist Pattern)

In the process for forming a resist pattern of the present invention, after a resist pattern to be thickened is formed, the resist pattern thickening material of the present invention is coated so as to cover the surface of the resist pattern to be thickened, and a resist pattern, in which the resist pattern to be thickened has been thickened, is formed.

Suitable examples of materials of the resist pattern to be thickened are the materials which are listed above in the discussion of the resist pattern thickening material of the present invention.

The resist pattern to be thickened can be formed in accordance with known methods.

The resist pattern to be thickened can be formed on an underlying layer (a base). The underlying layer (base) is not particularly limited, and can be appropriately selected in accordance with the object. However, when the resist pattern to be thickened is formed into a semiconductor device, the underlying layer (base) is usually a substrate such as a silicon wafer, or any of various types of oxide films, or the like.

The method of coating the resist pattern thickening material is not particularly limited, and can be appropriately selected from among known coating methods in accordance with the object. Suitable examples are a spin coating method and the like. In the case in which a spin coating method is used, the conditions are as follows for example: the rotational speed is about 100 rpm to 10,000 rpm, and is preferably 800 rpm to 5,000 rpm, and the time is about one second to 10 minutes, and 1 second to 90 seconds is preferable.

The coated thickness at the time of coating is usually about 10 nm (100 Å) to 1,000 nm (10,000 Å), and about 100 nm (1,000 Å) to 500 nm (5,000 Å) is preferable.

Note that, at the time of coating, the surfactant may be coated before and separately from coating of the resist pattern thickening material, without being contained in the resist pattern thickening material.

Carrying out prebaking (heating and drying) of the coated resist pattern thickening material during coating or after coating is preferable from the standpoint that the resist pattern thickening material can be efficiently mixed (impregnated) into the resist pattern to be thickened at the interface between the resist pattern to be thickened and the resist pattern thickening material.

The conditions, the method and the like of the prebaking (heating and drying) are not particularly limited and can be appropriately selected in accordance with the object, provided that they do not cause softening of the resist pattern to be thickened. For example, the temperature is about 40°C to 120°C, and 70°C to 100°C is preferable, and the time is about 10 seconds to 5 minutes, and 40 seconds to 100 seconds is preferable.

Carrying out baking of the coated resist pattern thickening material after the prebaking (heating and drying) is preferable from the standpoint that the mixing at the interface of the resist pattern to be thickened and the resist pattern thickening material can be made to proceed efficiently.

The conditions, the method and the like of the baking are not particularly limited and can be appropriately selected in accordance with the object. However, usually, a higher temperature than that at the prebaking (heating and drying) is used. The conditions of the baking are, for example, the temperature is about 70°C to 150°C, and 90°C to 130°C is preferable, and the time is about 10 seconds to 5 minutes, and 40 seconds to 100 seconds is preferable.

Carrying out developing processing of the coated resist pattern thickening material after the baking is preferable. In this case, carrying out developing processing is preferable in that, among the coated resist pattern thickening material, the portions thereof which have not mixed with the resist pattern to be thickened are dissolved and removed, and the resist pattern can be developed (obtained).

The same comments as those above regarding developing processing are applicable here as well.

The process for forming the resist pattern of the present invention will be described hereinafter with reference to the drawings.

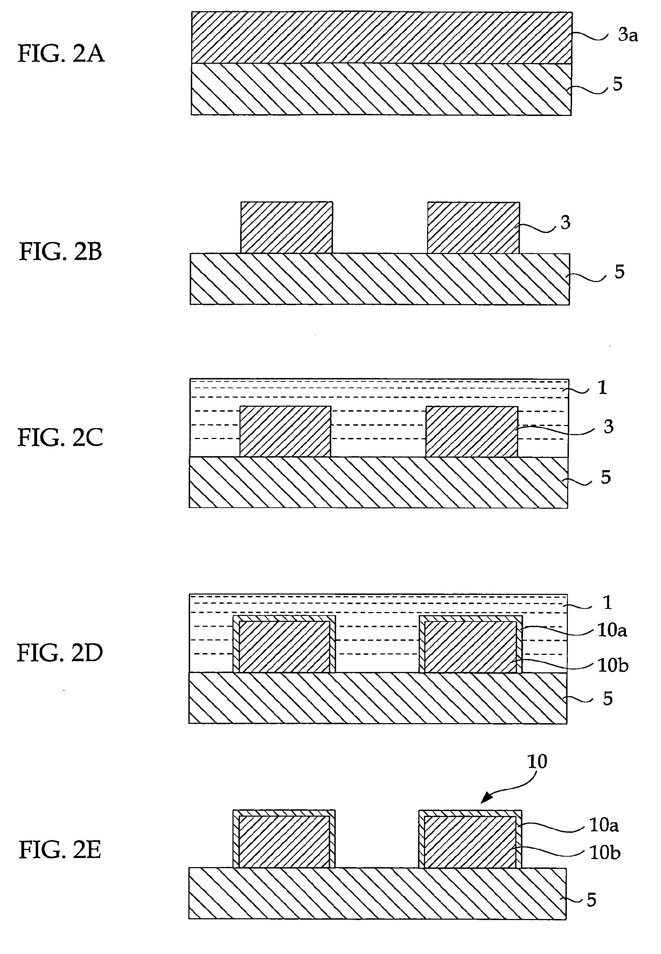

As shown in FIG. 2A, a resist material 3a is coated on the underlying layer (base) 5. Then, as shown in FIG. 2B, the resist material 3a is patterned such that the resist pattern to be thickened 3 is formed. Thereafter, as shown in FIG. 2C, the resist pattern thickening material 1 is coated on the surface of the resist pattern to be thickened 3, and prebaking (heating and drying) is carried out such that a coated film is formed. Then, mixing (impregnation) of the resist pattern thickening material 1 into the resist pattern to be thickened 3 takes place at the interface of the resist pattern to be thickened 3 and the resist pattern thickening material 1. As shown in FIG. 2D, a mixed (impregnated) layer is formed at the interface between the resist pattern to be thickened 3 and the resist pattern thickening material 1. Thereafter, as shown in FIG. 2E, by carrying out developing processing, among the coated resist pattern thickening material 1, the portions thereof which have not mixed with the resist pattern to be thickened 3 are dissolved and removed, such that the resist pattern 10 - having the surface layer 10a on the resist pattern 10b (the resist pattern to be thickened 3) is formed (developed).

The developing processing may be performed in water or an alkali aqueous solution. However, water developing is preferable from the standpoint that the developing processing can be carried out efficiently at a low cost.

The resist pattern 10 has, on the surface of the resist pattern 10b (the resist pattern to be thickened 3), the surface layer 10a which has been formed by the resist pattern thickening material 1 mixing. The resist pattern 10 is thicker than the resist pattern to be thickened 3 (the resist pattern 10b) by an amount corresponding to the thickness of the surface layer 10a. Thus, the width of the space pattern formed by the resist pattern 10 is smaller than that of a space pattern formed by the resist pattern to be thickened 3 (the resist pattern 10b), and the space pattern formed by the resist pattern 10 is fine.

The surface layer 10a of the resist pattern 10 is formed by the resist pattern thickening material 1. In a case in which the resist pattern thickening material 1 contains at least one of a cyclic structure-containing compound and/ or a resin having a cyclic structure in a portion thereof, the etching resistance is markedly improved. In this case, even if the resist pattern to be thickened 3 (the inner layer resist pattern 10b) is a material which has poor etching resistance, the resist pattern 10, which has on the surface thereof the surface layer 10a having excellent etching resistance, can be formed.

The (thickened) resist pattern which is formed by the process for forming a resist pattern of the present invention has, on the surface of the resist pattern to be thickened, the surface layer which is formed by the resist pattern thickening material of the present invention mixing. When the resist pattern thickening material contains at least one of a cyclic structure-containing compound and/ or a resin having a cyclic structure in a portion thereof in a portion thereof, even if the resist pattern to be thickened is a material having poor etching resistance, the (thickened) resist pattern, which has the surface layer having excellent etching resistance on the surface of the resist pattern to be thickened, can efficiently be fabricated. Further, the resist pattern which is fabricated by the process for forming a resist pattern of the present invention is thicker than the resist pattern to be thickened by an amount corresponding to the thickness of the surface layer. Therefore, the width of the space pattern formed by the fabricated, resist pattern 10 is smaller than that of a space pattern formed by the resist pattern to be thickened. Therefore, by using the process for forming a resist pattern of the present invention, a fine space pattern can be formed efficiently.

The resist pattern formed by the resist pattern thickening material of the present invention has, on the resist pattern to be thickened, the surface layer which is formed by the resist pattern thickening material of the present invention.

The resist pattern preferably has excellent etching resistance. It is preferable that the etching rate (nm/ s) of the resist pattern is equivalent to or greater than that of the resist pattern to be thickened. Specifically, when measurement is carried out under the same conditions, the ratio (resist pattern to be thickened /surface layer) of the etching rate (nm/ s) of the surface layer to the etching rate (nm/ s) of the resist pattern to be thickened is preferably 1.1 or more, and is more preferably 1.2 or more, and is particularly preferably 1.3 or more.

The etching rate (nm/ s) can be measured by, for example, carrying out etching processing for a predetermined time by using a known etching device, measuring the amount of film reduction of the sample, and calculating the amount of film reduction per unit time.

The surface layer can suitably be formed by using the resist pattern thickening material of the present invention. From the standpoint of improving the etching resistance, the surface layer preferably contains at least one of a cyclic structure-containing compound and a resin having a cyclic structure in a portion thereof.

Whether the surface layer does or does not contain at least one of a cyclic structure containing compound and a resin having a cyclic structure in a portion thereof, can be confirmed by, for example, analyzing the IR absorption spectrum of the surface layer.

The resist pattern may contain at least one of a cyclic structure-containing compound and a resin having a cyclic structure in a portion thereof. In this case, the content of the at least one of the cyclic structure-containing compound and/ or the resin having a cyclic structure in a portion thereof can be set so as to gradually decrease from the surface layer toward the interior.

In the resist pattern of the present invention, the border between the resist pattern to be thickened and the surface layer may be a clear structure, or may be an unclear structure.

The resist pattern fabricated by the process for forming a resist pattern of the present invention can suitably be used in, for example, the fabricating of functional parts such as mask patterns, reticle patterns, recording heads, LCDs (liquid crystal displays), PDPs (plasma display panels), SAW filters (surface acoustic wave filters), and the like; optical parts used in connecting optical wiring; fine parts such as microactuators and the like; semiconductor devices; and the like. The resist pattern can suitably be used in the process for manufacturing a semiconductor device of the present invention which will be described hereinafter.

### (Process for manufacturing Semiconductor Device)

The process for manufacturing a semiconductor device of the present invention has a resist pattern forming step, and a patterning step. The process may include other steps which are appropriately selected as needed.

The resist pattern forming step is a step of, after forming a resist pattern to be thickened on an underlying layer, coating the resist pattern thickening material of the present invention so as to cover the surface of the resist pattern to be thickened, thereby thickening the resist pattern to be thickened and forming a resist pattern. Details of the resist pattern forming step are the same as those of the process for forming a resist pattern of the present invention.

The underlying layer is not particularly limited, and can be appropriately selected in accordance with the object. Examples of the underlying layer are surface layers of various members in semiconductor devices. Suitable examples are substrates such as silicon wafers, surface layers thereof, various types of oxide films, and the like. The resist pattern to be thickened is as described above. The method of coating is as described above. Further, after the coating, it is preferable to carry out the above-described prebaking, baking, and the like.

The patterning step is a step of patterning the underlying layer by carrying out etching by using (as a mask pattern or the like) the resist pattern formed by the resist pattern forming step.

The method of etching is not particularly limited, and can be appropriately selected from among known methods in accordance with the object. Dry etching is a suitable example. The etching conditions are not particularly limited, and can be appropriately selected in accordance with the object.

Suitable examples of other steps are a surfactant coating step, a developing processing step, and the like.

The surfactant coating step is a step of coating a surfactant solution on the surface of the resist pattern to be thickened, before the resist pattern forming step.

The surfactant is not particularly limited, and can be appropriately selected in accordance with the object. Suitable examples are the surfactants listed above, and polyoxyethylene - polyoxypropylene condensation product compounds, polyoxyalkylene alkylether compounds, polyoxyethylene alkylether compounds, polyoxyethylene derivative compounds, sorbitan fatty acid ester compounds, glycerin fatty acid ester compounds, primary alcohol ethoxylate compounds, phenol ethoxylate compounds, and nonylphenol ethoxylate, octylphenol ethoxylate, lauryl alcohol ethoxylate, oleyl alcohol ethoxylate, fatty acid ester, amide, natural alcohol, ethylene diamine, secondary alcohol ethoxylate, alkyl cationic, amide quaternary cationic, ester quaternary cationic, amine oxide, and betaine surfactants, and the like.

The developing processing step is a step of carrying out developing processing of the coated resist pattern thickening material, after the resist pattern forming step and before the patterning step. Note that the developing processing is as described previously.

By using the process for manufacturing a semiconductor device of the present invention, it is possible to efficiently fabricate various types of semiconductor devices such as flash memories, DRAMs, FRAMs, and the like.

Hereinafter, Examples of the present invention will be concretely described. However, the present invention is not in any way limited to these Examples.

### (Example 1)

### - Preparation of Resist Pattern Thickening Material-

Resist pattern thickening materials 1 through 4 of the present invention having the compositions shown in Table 1 were prepared. Note that, in Table 1, the unit of the values in parentheses is parts by mass. In the "resin" column, "KW-3" is a polyvinyl acetal resin (manufactured by Sekisui Chemical Co., Ltd.). In the "surfactant" column, "TN-80" is a non-ionic surfactant (a polyoxyethylene monoalkylether surfactant manufactured by Asahi Denka Co., Ltd.), and "PC-6" is a non-ionic surfactant (a polyoxyethylene monoalkylether surfactant manufactured by Asahi Denka Co, Ltd.). Further, a mixed liquid of pure water (deionized water) and isopropyl alcohol (whose mass ratio was water (deionized water): isopropyl alcohol = 98.6 : 0.4) was used as the main solvent component other than the resin.

**TABLE 1**

| thickening material | resin | surfactant | added substance |
|---|---|---|---|
| 1 | KW-3 (16) | PC-6 (0.25) | - |
| 2 | KW-3 (16) | PC-6 (0.25) | adamantanol (0.8) |
| 3 | polyvinyl pyrrolidone (8) | TN-80 (0.25) | - |
| 4 | hydroxypropyl cellulose (8) | PC-6 (0.25) | - |

### - Forming of Resist Pattern -

The resist pattern thickening materials 1 through 4 of the present invention which were prepared as described above were coated onto isolated line patterns (width: 200 nm) formed by ArF resists (PAR700, manufactured by Sumitomo Chemical Co., Ltd.), by a spin coating method, first under the condition of 1000 rpm/5 s, and then under the condition of 3500 rpm/40 s. Thereafter, prebaking was carried out under the condition of 85°C/70 s, and then baking was carried out under the condition of 110°C /70 s. Thereafter, the resist pattern thickening materials 1 through 4 were rinsed for 60 seconds with pure water such that the portions which had not mixed were removed. By developing the resist patterns to be thickened which had been thickened by the resist pattern thickening materials 1 through 4, resist patterns were prepared.

The sizes of the space patterns formed by the resist patterns are shown in Table 2 together with the initial pattern sizes (the sizes of the space patterns formed by the resist patterns to be thickened before thickening). Note that, in Table 2, "1" through "4" correspond to the resist pattern thickening materials 1 through 4.

**TABLE 2**

| thickening material | initial pattern size (nm) | pattern size (nm) after processing |
|---|---|---|
| 1 | 203.3 | 187.1 |
| 2 | 202.6 | 187.6 |
| 3 | 200.8 | 188.1 |
| 4 | 201.8 | 192.6 |

Next, the resist pattern thickening materials 1 through 4 of the present invention were coated on the surfaces of resists formed on silicon substrates, and surface layers having a thickness of 0.5 µm were formed. Etching was carried out for three minutes under the conditions of Pµ = 200 W, pressure = 0.02 Torr, CF₄ gas = 100 sccm by using an etching device (a parallel plate type RIE device manufactured by Fujitsu Ltd.), on the surface layers, and on a KrF resist (UV-6 manufactured by Shipley Company, L.L.C.) for comparison, and on polymethyl methacrylate (PMMA) for comparison. The amounts of film reduction of the samples were measured, the etching rates were calculated, and relative evaluation was carried out by using the etching rate of the KrF resist as the standard.

**TABLE 3**

| material | etching rate (nm/ min) | ratio of rates |
|---|---|---|
| UV-6 | 62.7 | 1.00 |
| PMMA | 77.0 | 1.23 |
| 1 | 67.1 | 1.07 |
| 2 | 57.0 | 0.91 |
| 3 | 60.1 | 0.95 |
| 4 | 62.0 | 0.99 |

From the results of Table 3, it can be understood that the etching resistances of the resist pattern thickening materials of the present invention were near to that of the KrF resist and were markedly superior as compared with PMMA, and that resist pattern thickening material 2 using adamantanol which is an alicyclic compound had particularly excellent etching resistance.

### (Example 2)

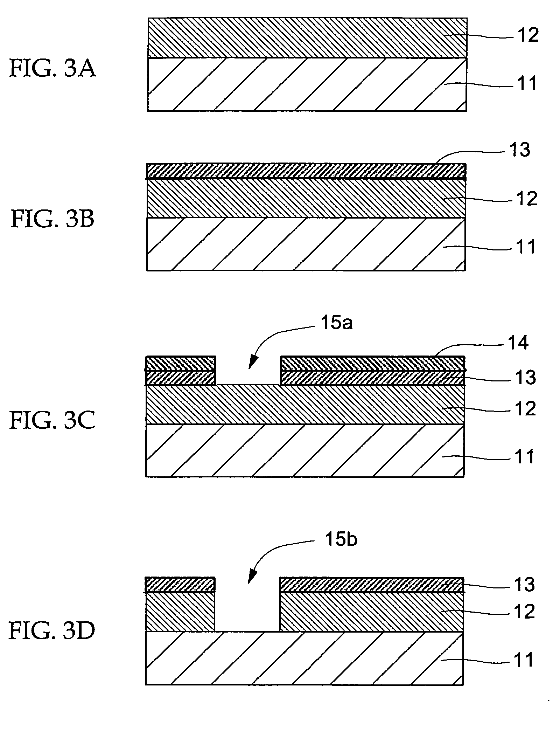

As shown in FIG. 3A, an interlayer insulating film 12 was formed on a silicon substrate 11. As shown in FIG. 3B, a titanium film 13 was formed by a sputtering method on the interlayer insulating film 12. Next, as shown in FIG. 3C, a resist pattern 14 was formed. By using the resist pattern 14 as a mask, the titanium film 13 was patterned by reactive ion etching such that openings 15a were formed. Subsequently, as shown in FIG. 3D, the resist pattern 14 was removed by reactive ion etching, and openings 15b were formed in the interlayer insulating film 12 by using the titanium film 13 as a mask.

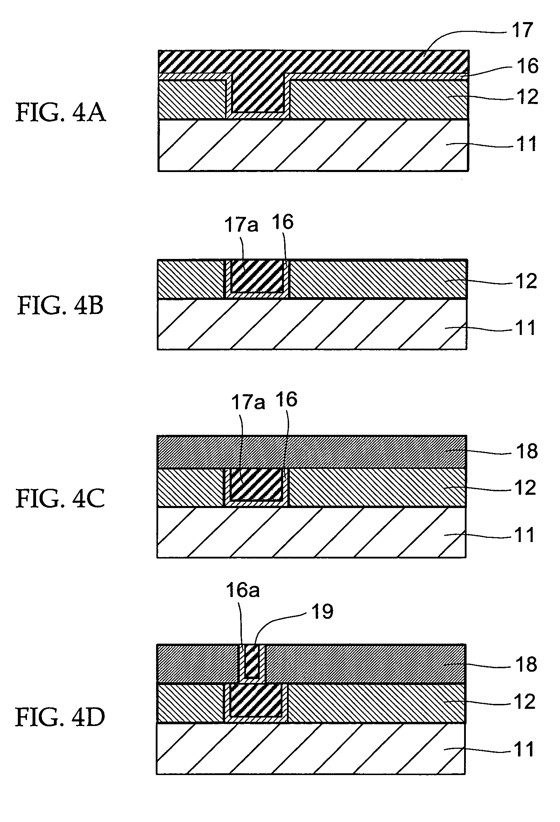

Next, the titanium film 13 was removed by wet processing, and as shown in FIG. 4A, a TiN film 16 was formed on the interlayer insulating film 12 by a sputtering method. Subsequently, a Cu film 17 was grown by an electrolytic plating method on the TiN film 16. Next, as shown in FIG. 4B, planarizing was carried out by CMP such that the barrier metal and the Cu film (first metal film) remained only in the groove portions corresponding to the openings 15b (FIG. 3D), and wires 17a of a first layer were formed.

Next, as shown in FIG. 4C, an interlayer insulating film 18 was formed on the wires 17a of the first layer. Thereafter, in the same way as in FIGs. 3B through 3D and FIGs. 4A and 4B, Cu plugs (second metal films) 19 and TiN films 16a, which connected the wires 17a of the first layer to upper layer wires which would be formed later, were formed as shown in FIG. 4D.

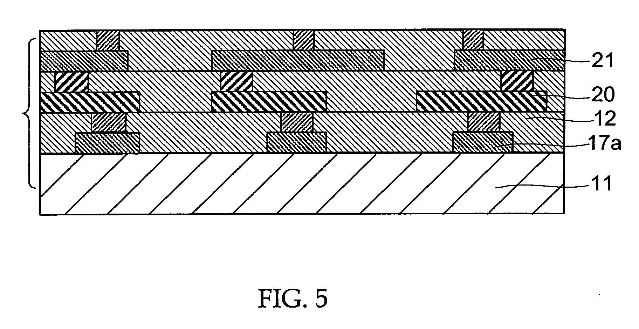

By repeating the above-described respective processes, as shown in FIG. 5, a semiconductor device was fabricated which had a multilayer wiring structure having, on the silicon substrate 11, the wires 17a of the first layer, wires 20 of a second layer, and wires 21 of a third layer. Note that the barrier metal layers formed beneath the wires of the respective layers are not shown in FIG. 5.

In present Example 2, the resist pattern 14 is a resist pattern fabricated in the same way as in the case of Example 1, by using the resist pattern thickening material of the present invention.

### (Example 3)

### - Flash Memory and Process for Manufacturing Thereof-

Example 3 is an example of the semiconductor device and process for manufacturing thereof of the present invention using the resist pattern thickening material of the present invention. Note that, in Example 3, resist films 26, 27, 29, 32, and 34 which will be described hereinafter are resist films which have been thickened by the same process as in Examples 1 and 2 by using the resist pattern thickening material of the present invention.

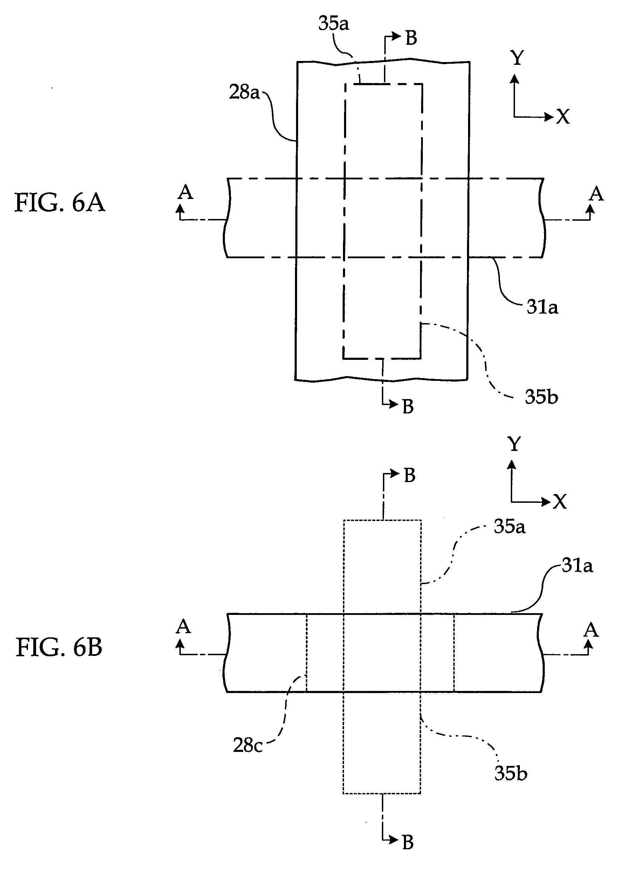

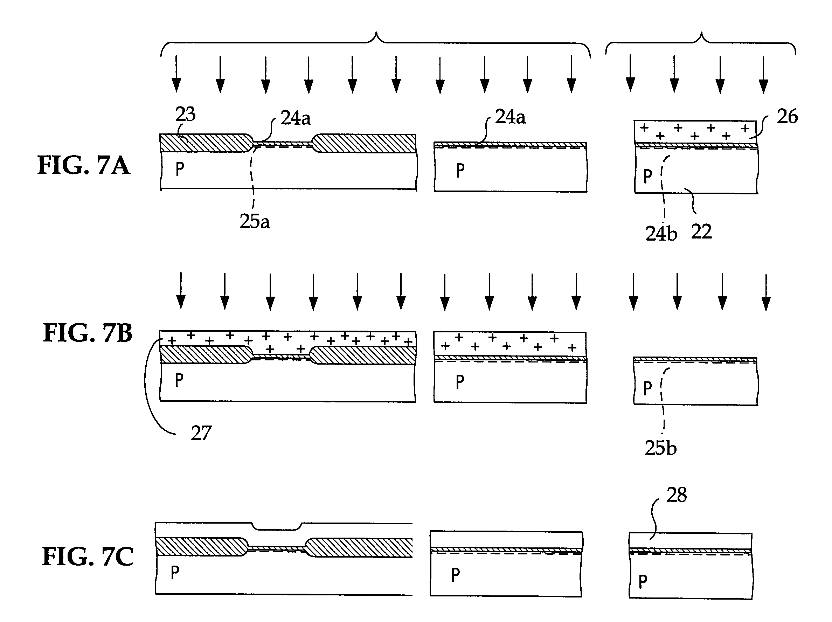

FIGs. 6A and 6B are top views (plan views) of a FLASH EPROM which is called a FLOTOX type or an ETOX type. Note that FIGs. 7A, 7B, 7C, 8D, 8E, 8F, 9G, 9H, and 9I are cross-sectional schematic views for explaining an example of a process for manufacturing the FLASH EPROM. In FIGs. 7A through 9I, the illustrations at the left sides are a memory cell portion (a first element region), and are schematic diagrams of the cross-section (the A direction cross-section) of the gate widthwise direction (the X direction in FIGS. 6A and 6B) of the portion at which a MOS transistor having a floating gate electrode is formed. The illustrations at the center are the memory cell portion, which is the same portion as in the left side drawings, and are schematic diagrams of the cross-section (the B direction cross-section) of the gate lengthwise direction (the Y direction in FIGS. 6A and 6B) which is orthogonal to the X direction. The illustrations at the right side are schematic diagrams of the cross-section (the A direction cross-section in FIGS. 6A and 6B) of the portion of the peripheral circuit portion (a second element region) at which a MOS transistor is formed.

First, as shown in FIG. 7A, a field oxide film 23 of SiO₂ was selectively formed at the element isolation region on a p type Si substrate 22. Thereafter, a first gate insulating film 24a was formed at the MOS transistor of the memory cell portion (the first element region), by an SiO₂ film by thermal oxidation so as to become a thickness of 10 nm (100 Å) to 30 nm (300 Å). In a separate process, a second gate insulating film 24b was formed at the MOS transistor of the peripheral circuit portion (the second element region), by an SiO₂ film by thermal oxidation so as to become a thickness of 10 nm (100 Å) to 50 nm (500 Å). Note that, when the first gate insulating film 24a and the second gate insulating film 24b are the same thickness, these oxide films may be formed simultaneously in the same process.

Next, in order to form a MOS transistor having depression type n-channels at the memory cell portion (the left side and the center in FIG. 7A), the peripheral circuit portion (the right side in FIG. 7A) was masked by a resist film 26 for the purpose of controlling the threshold voltage. Then, phosphorus (P) or arsenic (As) was introduced, as an n type impurity in a dosage amount of 1 × 10¹¹ cm⁻² to 1 × 10¹⁴ cm⁻² by an ion implantation method, into the regions which were to become the channel regions directly beneath the floating gate electrodes, such that a first threshold value control layer 25a was formed. Note that the dosage amount and the conductive type of the impurity at this time can be appropriately selected in accordance with whether depression type channels or accumulation type channels are to be formed.

Next, in order to form a MOS transistor having depression type n-channels at the peripheral circuit portion (the right side in FIG. 7B), the memory cell portion (the left side and the center in FIG. 7B) was masked by the resist film 27 for the purpose of controlling the threshold voltage. Then, phosphorus (P) or arsenic (As) was introduced, as an n type impurity in a dosage amount of 1 × 10¹¹ cm⁻² to 1 × 10¹⁴ cm⁻² by an ion implantation method, into the regions which were to become the channel regions directly beneath the gate electrodes, such that a second threshold value control layer 25b was formed.

Next, a first polysilicon film (a first conductor film) 28 having a thickness of 50 nm (500 Å) to 200 nm (2,000 Å) was coated over the entire surface as a floating gate electrode of the MOS transistor at the memory cell portion (the left side and the center in FIG. 7C) and as a gate electrode of the MOS transistor at the peripheral circuit portion (the right side in FIG. 7C).

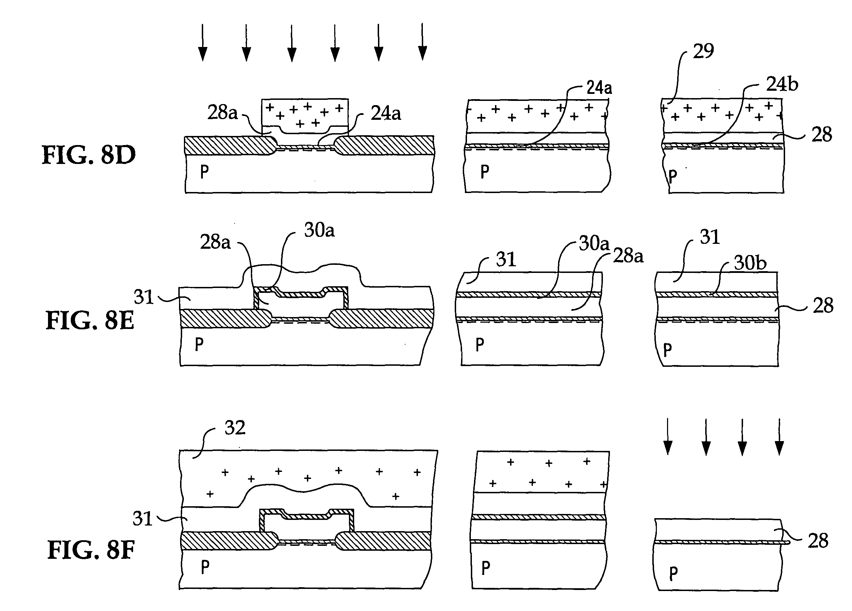

Thereafter, as shown in FIG. 8D, the first polysilicon film 28 was patterned by using a resist film 29 formed as a mask, such that a floating gate electrode 28a was formed at the MOS transistor at the memory cell portion (the left side and the center in FIG. 8D). At this time, as shown in FIG. 8D, in the X direction, patterning was carried out so as to obtain the final width, and in the Y direction, the region which was to become the S/D region layer remained covered by the resist film 29 without patterning.

Next, as shown in the left side and the center of FIG. 8E, after the resist film 29 was removed, a capacitor insulating film 30a formed of an SiO₂ film was formed by thermal oxidation to a thickness of approximately of 20 nm (200 Å) to 50 nm (500 Å) so as to cover the floating gate electrode 28a. At this time, a capacitor insulating film 30b formed of an SiO₂ film was formed on the first polysilicon film 28 of the peripheral circuit portion (the right side in FIG. 8E). Here, although the capacitor insulating films 30a and 30b were formed only by SiO₂ films, they may be formed by a composite film of two to three layers of SiO₂ and Si₃N₄ films.

Next, as shown in FIG. 8E, a second polysilicon film (a second conductor film) 31, which was to become a control gate electrode, was formed to a thickness of 50 nm (500 Å) to 200 nm (2,000 Å) so as to cover the floating gate electrode 28a and the capacitor insulating film 30a.

Then, as shown in FIG. 8F, the memory portion (the left side and the center of FIG. 8F) was masked by a resist film 32, and the second polysilicon film 31 and the capacitor insulating film 30b of the peripheral circuit portion (the right side in FIG. 8F) were successively removed by etching such that the first polysilicon film 28 was exposed at the surface.

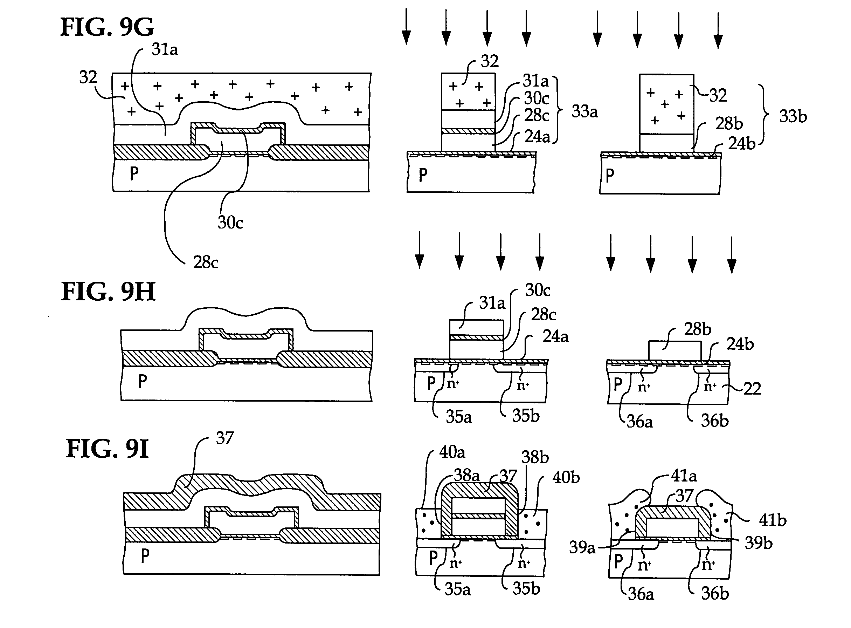

Subsequently, as shown in FIG. 9G, the second polysilicon film 31, the capacitor insulating film 30a and the first polysilicon film 28a which had been patterned only in the X direction, of the memory portion (the left side and the center of FIG. 9G), were, by using the resist film 32 as a mask, subjected to patterning in the Y direction so as to become the final dimension of a first gate portion 33a. A laminate structure formed by a control gate electrode 31a / a capacitor insulating film 30c / a floating gate electrode 28c, which had a width of approximately 1 µm in the Y direction, was formed. The first polysilicon film 28 of the peripheral circuit portion (the left side in FIG. 9G) was, by using the resist film 32 as a mask, subjected to patterning so as to become the final dimension of a second gate portion 33b, and a gate electrode 28b of a width of approximately 1 µm was formed.

Next, by using the laminate structure formed by the control gate electrode 31a / the capacitor insulating film 30c / the floating gate electrode 28c of the memory cell portion (the left side and the center of FIG. 9H) as a mask, phosphorus (P) or arsenic (As) was introduced, in a dosage amount of 1 × 10¹⁴ cm⁻² to 1 × 10¹⁶ cm⁻² by an ion implantation method, into the Si substrate 22 of the element forming region, such that n type S/D region layers 35a and 35b were formed. By using the gate electrode 28b at the peripheral circuit portion (the right side of FIG. 9H) as a mask, phosphorus (P) or arsenic (As) was introduced, as an n type impurity in a dosage amount of 1 × 10¹⁴ cm⁻² to 1 × 10¹⁶ cm⁻² by an ion implantation method, into the Si substrate 22 of the element forming region, such that S/D region layers 36a and 36b were formed.

Subsequently, the first gate portion 33a of the memory cell portion (the left side and the center of FIG. 9I) and the second gate portion 33b of the peripheral circuit portion (the right side of FIG. 9I) were covered by forming an interlayer insulating film 37 formed of a PSG film to a thickness of about 500 nm (5000 Å).

Thereafter, contact holes 38a, 38b and contact holes 39a, 39b were formed in the interlayer insulating film 37 formed on the S/ D region layers 35a, 35b and the S/D region layers 36a, 36b. Thereafter, S/D electrodes 40a, 40b and S/D electrodes 41a, 41b were formed.

In this way, as shown in FIG. 9I, the FLASH EPROM was fabricated as a semiconductor device.

In this FLASH EPROM, the second gate insulating film 24b of the peripheral circuit portion (the right side in FIGs. 7A through 9I) is covered (refer to the right side in FIGs. 7C through 9I) by the first polysilicon film 28 or the gate electrode 28b always after formation. Thus, the second gate insulating film 24b is maintained at the thickness at which it was initially formed. Thus, it is easy to control the thickness of the second gate insulating film 24b, and easy to adjust the concentration of the conductive impurity in order to control the threshold voltage.

Note that, in the above-described example, in order to form the first gate portion 33a, first, patterning is carried out at a predetermined width in the gate widthwise direction (the X direction in FIGS. 6A and 6B), and thereafter, patterning is carried out in the gate lengthwise direction (the Y direction in FIGS. 6A and 6B) so as to attain the final predetermined width. However, conversely, patterning may be carried out at a predetermined width in the gate lengthwise direction (the Y direction in FIGS. 6A and 6B), and thereafter, patterning may be carried out in the gate widthwise direction (the X direction in FIGS. 6A and 6B) so as to attain the final predetermined width.

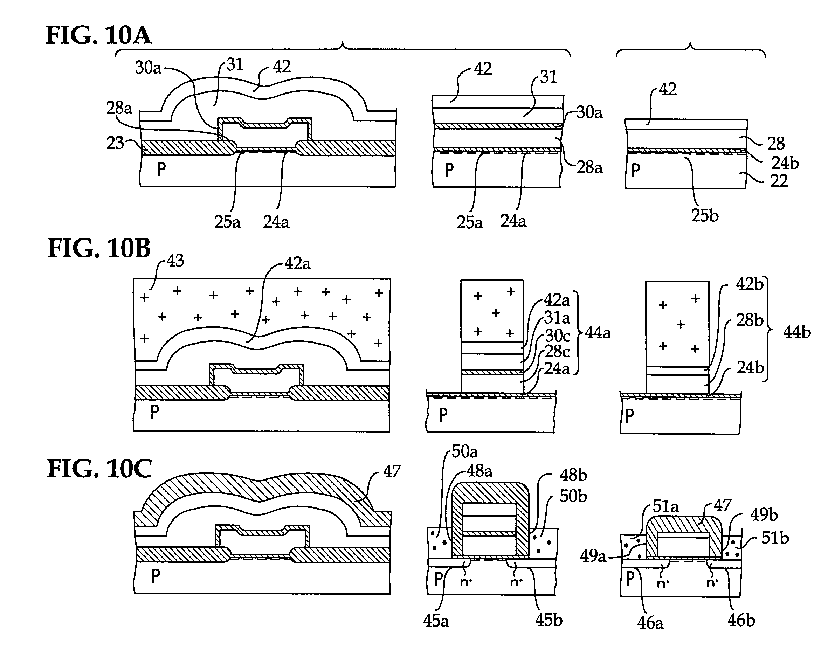

The example of fabricating a FLASH EPROM shown in FIGS. 10A through 10C is the same as the above-described example, except that the processes after the process shown by FIG. 8F in the above example are changed to the processes shown in FIGs.10A through 10C. Namely, as shown in FIG. 10A, this example differs from the above-described example only with respect to the point that a polycide film is provided by forming a high melting point metal film (a fourth conductor film) 42 formed of a tungsten (W) film or a titanium (Ti) film to a thickness of approximately 200 nm (2000 Å), on the second polysilicon film 31 of the memory cell portion shown at the left side and the center of FIG. 10A and on the first polysilicon film 28 of the peripheral circuit portion shown at the right side in FIG.10A. The processes after FIG.10A, i.e., the processes shown in FIGs.10B and 10C, are the same as those shown in FIGs. 9G through 9I. Explanation of the processes which are the same as those shown in FIGs. 9G through 9I is omitted. In FIGs.10A through 10C, portions which are the same as those in FIGs. 9G through 9I are denoted by the same reference numerals.

In this way, as shown in FIG. 10C, the FLASH EPROM was fabricated as a semiconductor device.

In this FLASH EPROM, high melting point metal films (the fourth conductor films) 42a and 42b were formed on the control gate electrode 31a and the gate electrode 28b. Thus, the electrical resistance value could be decreased even more.

Note that, here, the high melting point metal films (the fourth conductor films) 42a and 42b were used as the high melting point metal film (the fourth conductor film). However, a high melting point metal silicide film such as a titanium silicide (TiSi) film or the like may be used.

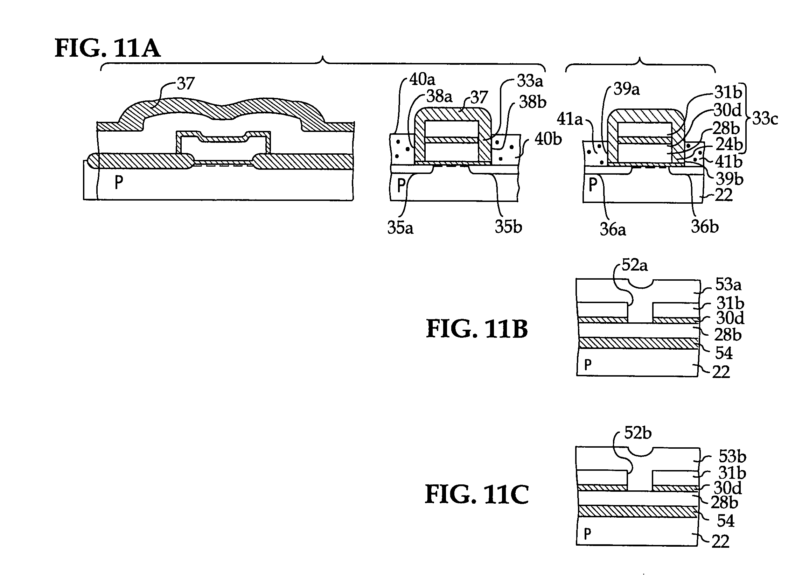

The example of fabricating a FLASH EPROM shown in FIGs. 11A through 11C is the same as the above-described example, except that a second gate portion 33c of the peripheral circuit portion (the second element region) (the right side in FIG.11A) also has the structure of the first polysilicon film 28b (first conductor film) / an SiO₂ film 30d (capacitor insulating film) / a second polysilicon film 31b (second conductor film) in the same way as the first gate portion 33a of the memory cell portion (the first element region) (the left side and center in FIG.11A), and that the first polysilicon film 28b and the second polysilicon film 31b are short-circuited so as to form a gate electrode as shown in FIG. 11B or FIG. 11C.

Here, as shown in FIG. 11B, an opening 52a, which passes through the first polysilicon film 28b (first conductor film) / the SiO₂ film 30d (capacitor insulating film) / the second polysilicon film 31b (second conductor film), is formed at a different place than, for example, a second gate portion 33c shown in FIG.11A, e.g., on an insulating film 54. A third conductive film, for example, a high melting point metal film 53a such as a W film or a Ti film or the like, is filled in the opening 52a. The first polysilicon film 28b and the second polysilicon film 31b are thereby short-circuited. Or, as shown in FIG. 11C, an opening 52b, which passes through the first polysilicon film 28b (first conductor film) / the SiO₂ film 30d (capacitor insulating film), is formed. The first polysilicon film 28b, the lower layer, is exposed at the bottom portion of the opening 52b. Thereafter, a third conductive film, for example, a high melting point metal film 53b such as a W film or a Ti film or the like, is filled in the opening 52b. The first polysilicon film 28b and the second polysilicon film 31b are thereby short-circuited.

In this FLASH EPROM, the second gate portion 33c of the peripheral circuit portion and the first gate portion 33a of the memory cell portion have the same structure. Thus, the peripheral circuit portion can be formed simultaneously with the formation of the memory cell portion. The fabricating process can thereby be simplified, which is efficient.

Note that, here, the third conductor film 53a or 53b was formed separately from the high melting point metal film (the fourth conductor film) 42. However, they may be formed simultaneously as a common high melting point metal film.

### (Example 4)

### - Fabricating of Recording Head -

Example 4 relates to the fabricating of a recording head as an applied example of the resist pattern of the present invention using the resist pattern thickening material of the present invention. Note that, in Example 4, resist patterns 102 and 126 which will be described hereinafter are resist patterns which have been thickened by the same process as in Example 1 by using the resist pattern thickening material of the present invention.

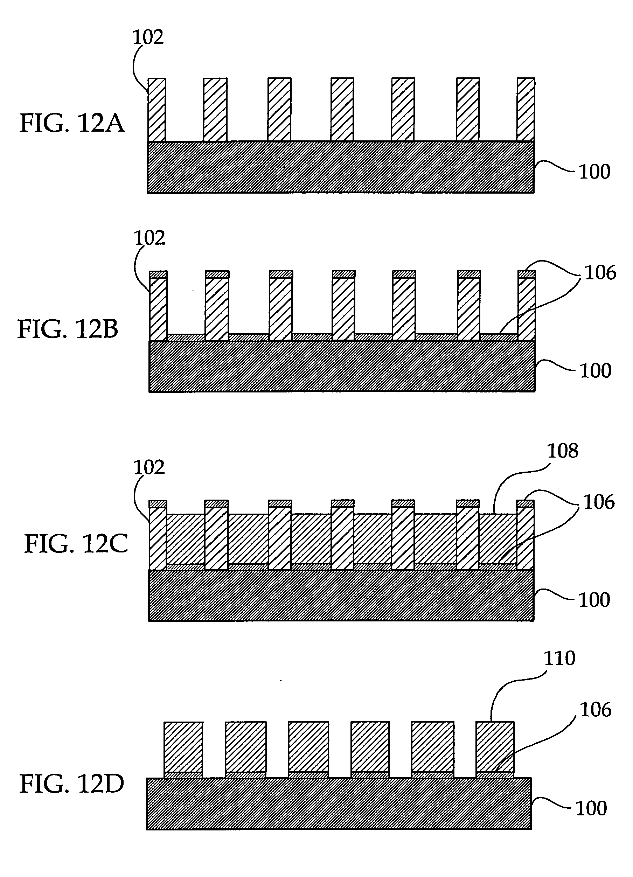

FIGs. 12A through 12D are process diagrams for explaining the fabricating of the recording head.

First, as shown in FIG. 12A, a resist film was formed to a thickness of 6 µm on an interlayer insulating film 100. Exposure and development were carried out, so as to form the resist pattern 102 having an opening pattern for formation of a spiral, thin film magnetic coil.

Next, as shown in FIG. 12B, a plating underlying layer 106 was formed by vapor deposition on the interlayer insulating layer 100, both on the resist pattern 102 and on the regions where the resist pattern 102 was not formed, i.e., the exposed surfaces of openings 104. The plating underlying layer 106 was a laminate of a Ti adhering film having a thickness of 0.01 µm and a Cu adhering film having a thickness of 0.05 µm.

Next, as shown in FIG. 12C, a thin film conductor 108, which was formed by a Cu plating film of a thickness of 3 µm, was formed on the interlayer insulating layer 100, at the regions where the resist pattern 102 was not formed, i.e., on the surfaces of the plating underlying layer 106 formed on the exposed surfaces of the openings 104.

Then, as shown in FIG. 12D, when the resist pattern 102 was melted and removed and lifted off from the interlayer insulating layer 100, a thin film magnetic coil 110, which was formed by the spiral pattern of the thin film conductor 108, was formed.

The recording head was thereby fabricated.

At the obtained recording head, the spiral pattern was formed to be fine by the resist pattern 102 which was thickened by using the resist pattern thickening material of the present invention. Thus, the thin film magnetic coil 110 was fine and detailed, and was extremely well suited to mass production.

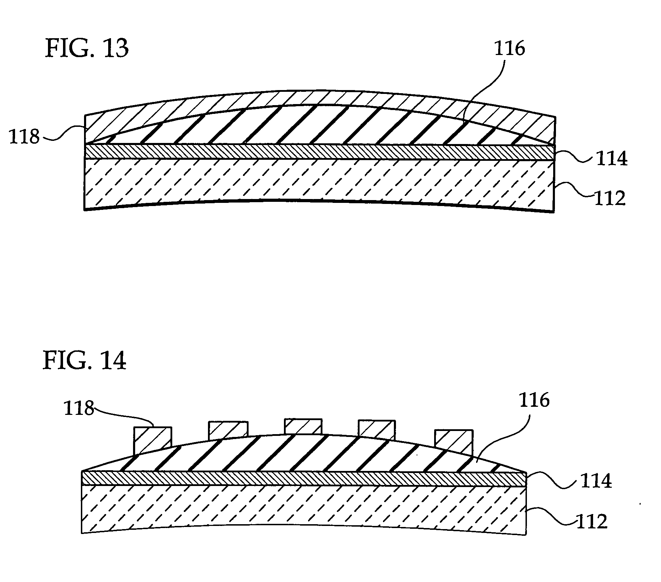

FIGs. 13 through 18 are process diagrams for explaining fabrication of another recording head.

As shown in FIG. 13, a gap layer 114 was formed by a sputtering method to cover a non-magnetic substrate 112 formed of ceramic. Note that an insulator layer (not illustrated) formed of silicon oxide and a conductive underlying layer and the like (not illustrated) formed of an Ni-Fe permalloy were formed in advance by a sputtering method to cover the non-magnetic substrate 112, and a lower portion magnetic layer (not illustrated) formed of an Ni-Fe permalloy was additionally formed on the non-magnetic substrate 112. Then, a resin insulating film 116, which was formed by a thermosetting resin, was formed on predetermined regions on the gap layer 114, except for the portions which were to become the magnetic distal end portions of the aforementioned unillustrated lower portion magnetic layer. Next, a resist material was coated on the resin insulating film 116 so as to form a resist film 118.

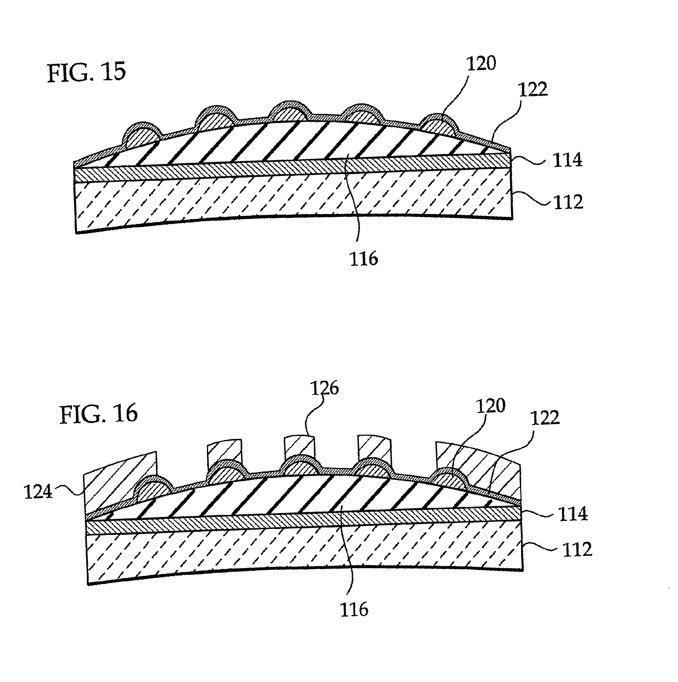

Then, as shown in FIG. 14, the resist film 118 was exposed and developed, such that a spiral pattern was formed. Subsequently, as shown in FIG. 15, the resist film 118 of the spiral pattern was subjected to thermosetting processing for about one hour at a temperature of several hundred degrees Celsius, such that a first spiral pattern 120, which was shaped as projections, was formed. Then, a conductive underlying layer 122 formed of Cu was formed to cover the surface of the first spiral pattern 120.

Next, as shown in FIG. 16, a resist material was coated on the conductive underlying layer 122 by a spin coating method so as to form a resist film 124. Thereafter, the resist film 124 was patterned on the first spiral pattern 120, such that the resist pattern 126 was formed.

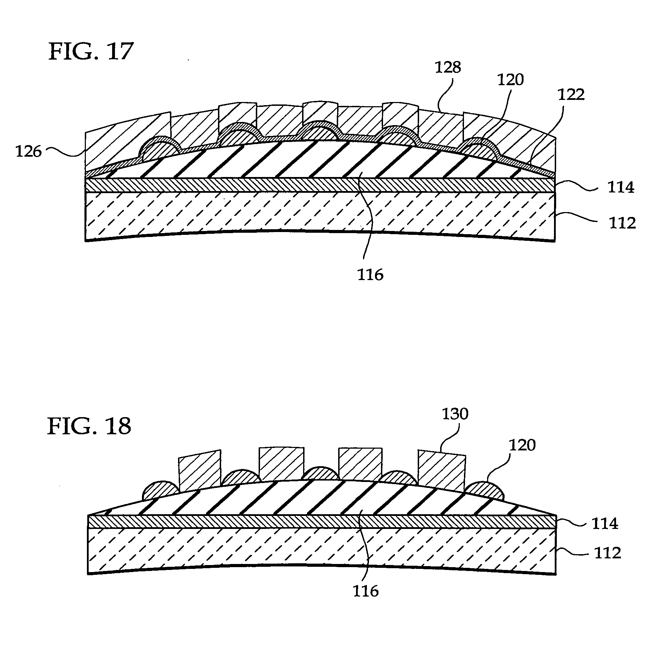

Then, as shown in FIG. 17, a Cu conductor layer 128 was formed by a plating method on the exposed surface of the conductive underlying layer 122, i.e., at the regions where the resist pattern 126 was not formed. Thereafter, as shown in FIG. 18, by dissolving and removing the resist pattern 126, the resist pattern 126 was lifted-off from the conductive underlying layer 122, such that a spiral, thin film magnetic coil 130 formed of the Cu conductor layer 128 was formed.

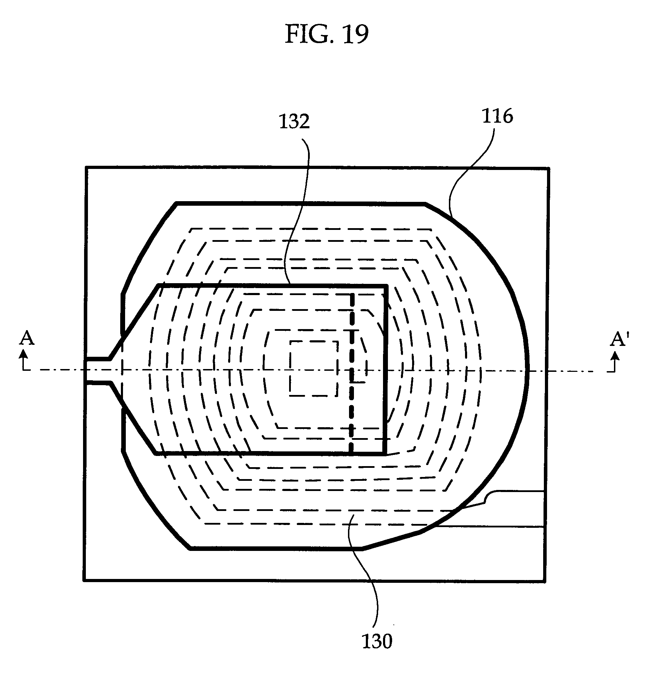

In this way, a recording head, such as that shown in plan view in FIG. 19, was fabricated which had a magnetic layer 132 on the resin insulating film 116 and had the thin film magnetic coil 130 on the surface.

At the obtained magnetic head, the spiral pattern was formed to be fine by the resist pattern 126 which was thickened by using the resist pattern thickening material of the present invention. Therefore, the thin film magnetic coil 130 was fine and detailed, and was extremely well suited to mass production.

The present invention provides a process for forming a resist pattern which, during patterning a resist pattern to be thickened, can utilize, as is, light sources (such as ArF excimer laser light and the like) of existing exposure devices, and which has excellent mass productivity, and which can finely form a space pattern, exceeding the exposure limits of such light sources.

Further, the present invention also provides a resist pattern thickening material which, when coated on a resist pattern to be thickened, can efficiently thicken the resist pattern to be thickened, and which is suited to the fabrication of a fine space pattern exceeding the exposure limits of light sources of existing exposure devices.

Moreover, the present invention provides a process for manufacturing a semiconductor device which, by using a space pattern, which has been formed to be fine, as a mask pattern, can form a fine pattern on an underlying layer which is an oxide film or the like, and which can efficiently mass produce high-performance semiconductor devices having fine wiring and the like.

## Claims

1. A resist pattern thickening material comprising:
a resin; and
a surfactant.

2. A resist pattern thickening material according to Claim 1, wherein the resist pattern thickening material is at least one of water-soluble and alkali-soluble.

3. A resist pattern thickening material according to Claim 1 or Claim 2, wherein the surfactant is at least one selected from a non-ionic surfactant, a cationic surfactant, an anionic surfactant, and an amphoteric surfactant.

4. A resist pattern thickening material according to Claim 3, wherein the non-ionic surfactant is selected from a polyoxyethylene - polyoxypropylene condensation product compound, a polyoxyalkylene alkylether compound, a polyoxyethylene alkylether compound, a polyoxyethylene derivative compound, a sorbitan fatty acid ester compound, a glycerin fatty acid ester compound, a primary alcohol ethoxylate compound, a phenol ethoxylate compound, an alkoxylate surfactant, a fatty acid ester surfactant, an amide surfactant, an alcohol surfactant, and an ethylene diamine surfactant;
the cationic surfactant is selected from an alkyl cationic surfactant, an amide quaternary cationic surfactant, and an ester quaternary cationic surfactant; and
the amphoteric surfactant is selected from an amine oxide surfactant and a betaine surfactant.

5. A resist pattern thickening material according to any one of Claims 1 to 4, wherein the resin is at least one of water-soluble and alkali-soluble.

6. A resist pattern thickening material according to any one of Claims 1 to 5, wherein the resin is at least one selected from a polyvinyl alcohol, a polyvinyl acetal, and a polyvinyl acetate.

7. A resist pattern thickening material according to any one of Claims 1 to 6, wherein the resin has a cyclic structure in at least a portion thereof.

8. A resist pattern thickening material according to Claim 7, wherein the cyclic structure is selected from at least one of an aromatic compound, an alicyclic compound, and a heterocyclic compound.

9. A resist pattern thickening material according to any one of Claims 1 to 8, further comprising a cyclic structure-containing compound.

10. A resist pattern thickening material according to Claim 9, wherein the cyclic structure-containing compound is at least one of water-soluble and alkali-soluble.

11. A resist pattern thickening material according to Claim 9 or Claim 10, wherein the cyclic structure-containing compound is selected from at least one of an aromatic compound, an alicyclic compound, and a heterocyclic compound.

12. A resist pattern thickening material according to Claim 11, wherein
the aromatic compound is selected from a polyphenol compound, an aromatic carboxylic acid compound, a naphthalene polyhydroxy compound, a benzophenone compound, a flavonoid compound, a derivative thereof, and a glycoside thereof; and
the alicyclic compound is selected from a polycycloalkane, a cycloalkane, a steroid, a derivative thereof, and a glycoside thereof.

13. A resist pattern thickening material according to any one of Claims 1 to 12, further comprising an organic solvent.

14. A resist pattern thickening material according to Claim 13, wherein the organic solvent is at least one selected from an alcohol solvent, a chain ester solvent, a cyclic ester solvent, a ketone solvent, a chain ether solvent, and a cyclic ether solvent.

15. A resist pattern comprising:
a resist pattern thickening material according to any one of Claims 1 to 14 to cover a surface of a resist pattern to be thickened so as to thicken the resist pattern to be thickened,
wherein the resist pattern thickening material is applied onto the resist pattern to be thickened after forming the resist pattern to be thickened.

16. A process for forming a resist pattern, comprising the steps of:
forming a resist pattern to be thickened;
coating a resist pattern thickening material according to any one of Claims 1 to 14 so as to cover a surface of the resist pattern to be thickened; and
forming a resist pattern in which the resist pattern to be thickened is thickened.

17. A process for forming a resist pattern according to Claim 16, wherein developing processing of the resist pattern thickening material is carried out after coating of the resist pattern thickening material.

18. A semiconductor device comprising a pattern formed by using a resist pattern which has been thickened by a resist pattern thickening material according to any one of Claims 1 to 14.

19. A process for manufacturing a semiconductor device comprising the steps of:
forming a resist pattern wherein, after forming a resist pattern to be thickened on an underlying layer, the resist pattern to be thickened is coated by a resist pattern thickening material according to any one of Claims 1 to 14 so as to cover a surface of the resist pattern to be thickened, so as to form a resist pattern in which the resist pattern to be thickened is thickened; and
patterning the underlying layer by etching by using the resist pattern.

20. A process for manufacturing a semiconductor device according to Claim 19, wherein a material of the resist pattern to be thickened is at least one selected from novolak resists, polyhydroxystyrene (PHS) resists, acrylic resists, cycloolefin - maleic acid anhydride resists, cycloolefin resists, and cycloolefin - acryl hybrid resists.
